# FASCICULE DE BREVET EUROPEEN

(11) **EP 3 028 279 B1**
(45) Date de publication et mention de la délivrance du brevet: **02.03.2022**
(21) Numéro de dépôt: 14745171.0
(22) Date de dépôt: 01.08.2014
(51) Int. Cl.: G11C 11/18, G11C 11/16, G11C 19/08

(54) **DISPOSITIF MEMOIRE AVEC SKYRMIONS MAGNETIQUES ET PROCEDE ASSOCIE**
SPEICHER MIT MAGNETISCHEN SKYRMIONEN UND ENTSPRECHENDES VERFAHREN
MEMORY WITH MAGNETIC SKYRMIONS AND METHOD RELATED THERETO

(30) Priorité: 01.08.2013 FR 1301854
(43) Date de publication de la demande: 08.06.2016
(73) Titulaire: THALES, 92200 Neuilly sur Seine (FR); Centre National de la Recherche Scientifique (C.N.R.S.), 75016 Paris (FR); Université Paris-Saclay, 91190 Gif-sur-Yvette (FR)
(72) Inventeur: CROS, Vincent, F-75011 Paris (FR); FERT, Albert, F-91767 Palaiseau Cedex (FR); SAMPAIO, Joao, F-75014 Paris (FR); SENEOR, Pierre, F-75013 Paris (FR)
(74) Mandataire: Lavoix
(86) Numéro de dépôt international: PCT/EP2014/066666
(87) Numéro de publication internationale: WO 2015/015007

(56) Documents cités:
- Albert Fert ET AL: "Skyrmions on the track", Nature Nanotechnology, 5 mars 2013 (2013-03-05), pages 152-156, XP055118996, Extrait de l'Internet: URL:http://www.nature.com/nnano/journal/v8 /n3/pdf/nnano.2013.29.pdf [extrait le 2014-05-20]
- A Fert ET AL: "Skyrmions, high density information storage, spintronic devices", , 4 février 2013 (2013-02-04), XP055119085, Extrait de l'Internet: URL:https://www.ntu.edu.sg/ias/upcomingeve nts/SCHLDS13/Documents/Lecture Notes/AlbertFert_04Feb13_Lecture2.pdf [extrait le 2014-05-20]
- YOUNGBIN TCHOE ET AL: "Skyrmion generation by current", PHYSICAL REVIEW B, vol. 85, no. 17, 12 mai 2012 (2012-05-12), XP055119150, ISSN: 1098-0121, DOI: 10.1103/PhysRevB.85.174416
- N. ROMMING ET AL: "Writing and Deleting Single Magnetic Skyrmions", SCIENCE, vol. 341, no. 6146, 9 août 2013 (2013-08-09), pages 636-639, XP055118966, ISSN: 0036-8075, DOI: 10.1126/science.1240573

## Description

La présente invention concerne un dispositif à mémoire, comprenant au moins un élément spintronique adapté pour représenter un état parmi au moins n états associés à l'élément spintronique, n étant supérieur à 1.

Pour rappel, le domaine spintronique, encore appelé domaine à électronique de spin, est un domaine de l'électronique utilisant le spin de l'électron comme vecteur de l'information.

De tels dispositifs à mémoire sont par exemple des dispositifs de stockage de masse, des registres à décalage, des dispositifs logiques et mémoires analogiques par exemple pour des circuits de type neuro-inspiré.

Tous ces dispositifs de mémoire à élément(s) spintronique(s), qui ont l'avantage d'être non volatiles, compatibles CMOS et résistant aux radiations électromagnétiques, sont basés sur un élément spintronique appelé Jonction Tunnel Magnétique (MTJ) qui est un empilement principalement constitué de deux couches magnétiques minces (quelques nanomètres) séparées par une couche isolante (de l'ordre du nanomètre).

Pour un élément spintronique de type mémoire binaire, le bit de la mémoire correspond à une MTJ de quelques dizaines à quelques centaines de nanomètres de côté dont l'état, alternativement 0 et 1, est obtenu par deux configurations possibles de la direction relative des aimantations dans les deux couches magnétiques (Parallèle ou Antiparallèle). La lecture de l'état de la mémoire se fait par la mesure de la tension aux bornes de la MTJ grâce à l'effet de magnétorésistance à effet tunnel, encore nommée TMR. L'écriture de l'état est effectuée, dans les dernières générations d'élément (appelé STT-MRAM), par effet de transfert de spin (Spin Transfer Torque en anglais, noté STT) qui permet d'agir sur la direction d'une (ou des) aimantation(s) et donc de modifier leur configuration par injection d'un courant polarisé en spin, en passant de Parallèle à Antiparallèle ou vice versa, sans nécessité d'appliquer un champ magnétique.

Dans les dispositifs plus complexes tels que les dispositifs de registre à décalage ou les memristors spintroniques, les modifications d'état sont basées sur le déplacement contrôlé de parois de domaines magnétiques. De la même façon que pour les éléments spintronique à mémoire binaire, la lecture est effectuée par effet magnétorésistif et l'écriture est réalisée par effet de transfert de spin.

Plusieurs problèmes techniques restent à résoudre dans les technologies existantes de dispositifs de mémoire à élément(s) spintronique. Premièrement, il est nécessaire de réduire la consommation énergétique associée à l'écriture de l'information. En effet, le coût en énergie a augmenté avec la diminution des dimensions des composants. Cette augmentation est liée à la nécessité de préserver ou même d'augmenter l'efficacité des effets de transfert de spin qui sont utilisés pour écrire l'information (par renversement de la direction de l'aimantation) et à l'influence accrue des défauts naturels ou liés à la nano-fabrication qui imposent d'injecter des densités de courant de plus en plus importantes pour atteindre les régimes d'écriture non stochastique.

Il est également souhaitable, tout en réduisant la consommation électrique (utilisée pour les différentes fonctions de la mémoire), de préserver une intensité de signal mesurée suffisante pour une bonne détection de l'état de la mémoire.

Deuxièmement, il est nécessaire d'augmenter la densité d'information pouvant être stockée dans les mémoires spintroniques non volatiles, ce qui pourrait se faire soit en augmentant le niveau d'intégration (i.e diminution de la taille du bit individuel) soit en allant au-delà des architectures de mémoires standards qui sont binaires.

Une solution consiste à disposer de mémoires à multi-états, dits encore à multiniveaux. Cependant, dans les mémoires magnétiques existantes, la commutation entre deux directions différentes des aimantations uniformes ne permet de coder qu'un seul bit par élément de mémoire. L'existence de mémoires à multi-états permettrait d'augmenter fortement la densité de stockage et d'en réduire le coût.

Il est également connu d'autres dispositifs de l'article intitulé "Skyrmions on the track" d'Albert Fert et al. (Nature Nanotechnology, 5 mars 2013, pages 152 à156, de l'article intitulé "Skyrmions, high density information storage, spintronics device" d'Albert Fert et al. daté du 4 février 2013 et de l'article "Skyrmion génération by current" de Youngbin Tchoe et al. (PHYSICALREVIEW B, vol. 85, n°17, 12 mai 2012).

Dans le but d'adresser les problématiques majeures des mémoires à élément spintronique (MRAM ou encore mémoire à registre à décalage à base de parois de domaines magnétiques), suivant un premier aspect, l'invention propose ainsi un dispositif à mémoire selon la revendication 1.

Un tel dispositif permet de fournir une mémoire à multi-états, d'augmenter la densité d'information pouvant être stockée par rapport au dispositif à mémoire spintronique de l'art antérieur et de réduire la consommation énergétique associée à l'écriture de l'information.

La présente invention vise ainsi à proposer une solution permettant de répondre aux problématiques techniques indiquées ci-dessus en utilisant des configurations magnétiques chirales que sont les skyrmions magnétiques comme support d'information avec un élément à mémoire multi-états.

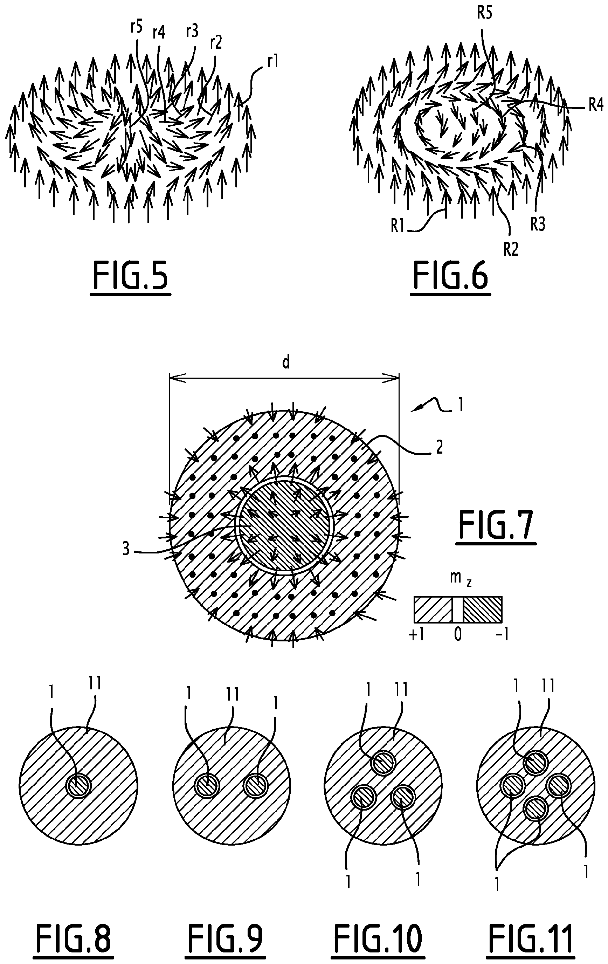

Les skyrmions sont des entités topologiques qui présentent une structure chirale de spin (c'est-à-dire une structure de spin symétrique par rapport à un miroir plan) dont la taille peut être extrêmement petite (jusqu'à quelques mailles atomiques) et le sens de rotation est imposé. La configuration de ces structures de spin peut être de type « hérisson » (cf. figure 5 où les flèches signalent l'orientation des spins organisés en cercles concentriques r1, r2, r3, r4 et r5)) ou « vortex » (cf. figure 6 où les flèches signalent l'orientation des spins organisés en cercles concentriques R1, R2, R3, R4 et R5).

Ces structures magnétiques chirales ont été prédites et observées dans des cristaux tels que MnSi, FeCoSi ou encore FeGe ayant une structure cristalline présentant une brisure de symétrie d'inversion. Dans les systèmes de films minces magnétiques qui sont ceux adressés par l'invention, la brisure de symétrie d'inversion nécessaire à la stabilisation d'une structure magnétique chirale est induite par la présence d'une interface entre un film mince magnétique et un film mince à fort couplage spin orbite (encore appelé SOC ou interaction spin-orbite), ce qui génère une forte interaction DM, caractérisée par un paramètre nommé D, donnant lieu à la stabilisation des configurations magnétiques de type skyrmion.

On rappelle que le SOC décrit les interactions entre le spin d'une particule (l'électron dans notre cas) et son mouvement, et revêt une importance particulière en magnétisme, et particulièrement en spintronique, pour expliquer un certain nombre de propriétés fondamentales des matériaux telles que par exemple les anisotropies magnétiques, les effets magnétorésistifs ou encore les processus de relaxation d'aimantation.

L'invention exploite ces interactions spin-orbite pour générer et/ou déplacer ces états magnétiques, appelés skyrmions magnétiques, dans des systèmes de type nanostructure.

On notera que les skyrmions sont protégés topologiquement et donc relativement stables aux variations des paramètres extérieurs ; ils ne peuvent pas être transformés (une fois stabilisés) pour transiter vers un autre ordre magnétique (quasi-uniforme ou vortex par exemple. Comme indiqué précédemment, les skyrmions magnétiques ont été observés seulement en 2009 dans des systèmes de type monocristaux (MnSi, FeCoSi, FeGe...) présentant une absence de symétrie d'inversion liée à la structure cristalline. Ces systèmes dit massifs ne peuvent pas être réduits fortement en épaisseur, ne sont pas compatibles avec les technologies CMOS et surtout ne présentent la phase comportant des réseaux ultra-denses de skyrmions qu'à basse température et sous champ magnétique.

En plus de l'interaction spin orbite, d'autres types d'interaction magnétique, par exemple les interactions dipolaires, peuvent permettre de stabiliser des configurations magnétiques chirales dans des nanostructures, qui sont appelées bulles magnétiques qui peuvent avoir dans le cas de systèmes de films minces magnétiques une structure de spin en hérisson, telle que présentée sur la figure 6. Dans le présent document, notamment dans la description et les revendications ci-après, nous regroupons sous la dénomination générale de skyrmion magnétique les structures de spin présentées sur le figure 6.

Dans des modes de réalisation, le dispositif à mémoire suivant l'invention comporte en outre une ou plusieurs des caractéristiques des revendications 2 à 9.

Suivant un deuxième aspect, la présente invention propose un procédé de traitement dans un dispositif à mémoire tel que décrit plus haut, le procédé étant selon la revendication 10.

Ces caractéristiques et avantages de l'invention apparaîtront à la lecture de la description qui va suivre, donnée uniquement à titre d'exemple, et faite en référence aux dessins annexés, sur lesquels :
- la figure 1 est une vue de dessus d'un dispositif à mémoire dans un mode de réalisation de l'invention ;
- la figure 2 est une vue latérale d'un dispositif à mémoire dans un mode de réalisation de l'invention ;
- la figure 3 est une vue de dessus du dispositif à mémoire de la figure 2 ;
- la figure 4 représente d'une part l'évolution de l'énergie totale d'une nanostructure selon l'invention en fonction d'un paramètre D;l'insert de la figure 4 représente l'évolution du diamètre d'un skyrmion en fonction de D pour différents diamètres du nanoplot ;
- la figure 5 est une vue d'un type de structure de skyrmion ;
- la figure 6 est une vue d'un autre type de structure de skyrmion ;
- la figure 7 est une vue d'un skyrmion dans un nanoplot ;
- les figures 8 à 11 représentent des vues d'un nanoplot comportant des nombres distincts de skyrmions ;
- les figures 12 à 13 représentent des vues d'un nanoplot associés à des états distincts dans un mode de réalisation de l'invention ;
- les figures 14 à 17 représentent des vues d'un nanoplot associés à des états distincts dans un mode de réalisation de l'invention.

L'invention propose d'utiliser ces configurations magnétiques chirales que sont les skyrmions magnétiques, comme support de l'information pour un élément à mémoire multi-états.

Dans un mode de réalisation, l'invention utilise comme structure de base nommée SB ci-après, un système hybride quasi bi-dimensionnel (car il comporte des épaisseurs de films de quelques plans atomiques qui sont beaucoup plus petites que les autres dimensions du système) comportant une nanostructure composée d'au moins un empilement d'une couche ultra-mince en matériau ferromagnétique et d'une couche d'un métal, non magnétique, à fort SOC.

Dans un mode de réalisation, le film ultramince magnétique est remplacé par un empilement de couches comprenant des couches ferro-magnétique(s) (et éventuellement non ferromagnétique(s), comme par exemple Co/Ni/Co/Ni, mais la brisure de symétrie à une ou plusieurs des interfaces avec un matériau à fort SOC doit être préservée.

La brisure de symétrie existant à l'interface entre ces deux couches est utilisée pour faciliter la création et la stabilisation de skyrmions en nombre limité et contrôlé (cf Fert et al, Nature Nano, 8, 152 (2013)).

Une observation expérimentale à très basse température de réseaux de skyrmions dans un système hybride ultra-mince comportant une couche ultra-mince de Fe sur Ir (111), est par exemple décrite dans « Spontaneous atomic-scale magnetic skyrmion lattice in two dimensions », Heinze et al., Nature Physics, 2011.

Les matériaux utilisés pour constituer la couche magnétique de la structure SB peuvent être typiquement du Fer (Fe), Colbalt (Co), Nickel (Ni) ou un alliage à base de ces métaux ou une multicouche à aimantation perpendiculaire ou des empilements de tels matériaux magnétiques ou un péreovskite férromagnétique simple ou double à base de Ti, Cr, Mn, Fe Co Mo ou Ru, ou des alliages de type Heusler ou des semi-conducteurs magnétiques, par exemple GaMnAs, ou des couches organiques magnétiques.Typiquement, l'épaisseur de la ou des couche(s) ferromagnétique(s) est de quelques plans atomiques, et est entre 0,2 nm et 3 nm.

Les matériaux utilisés pour constituer la couche à fort couplage spin-orbite peuvent être par exemple, selon le tableau périodique des éléments, un élément 5d comme le Platine (Pt), Tungstène (W), Iridium (Ir), Rhénium (Re), Tantale (Ta), Plomb (Pb), Bismuth (Bi) ou bien un élément 4d comme le Palladium (Pd), le Rhodium (Rh), ou un alliage de certains de ces éléments ou bien un empilement de tels matériaux par exemple Bi/Ag (Ag représente l'Argent) ou Au/Ag où Au représente l'or ou encore un élément 3d tel que le cuivre (Cu) ou le molybdène (Mo) ou bien un élément des Terres Rares comme le Samarium (Sm), le Gadolinium(Gd), le Terbium (Tb) ou l'Erbium (Er) par exemple.

Typiquement, l'épaisseur de la couche à fort SOC est entre 0,2 nm et 10 nm.

Une telle nanostructure permet d'obtenir des skyrmions isolés, en nombre contrôlable.

L'invention est relative à des dispositifs à mémoire comprenant une ou plusieurs nanostructures SB.

Une vue de dessus d'une telle nanostructure SB formant un élément spintronique 1, appelé ci-après nanoplot, d'un dispositif à mémoire selon l'invention est représentée sur la figure 7. Dans l'état considéré, le nanoplot 1 de diamètre d égal à 80 nanomètres (nm) comporte sur la couche ferromagnétique 3 de Co, un skyrmion magnétique 3 stabilisé. La direction de l'aimantation est indiquée par les flèches, et m_{z} représente la composante de l'aimantation pointant hors du plan du (ou des) film(s) magnétique(s) Celle-ci a été normalisée par rapport à la valeur de l'aimantation à saturation et la valeur de m_{z} représente la direction vers laquelle l'aimantation pointe : elle vaut +1 quand elle pointe vers le haut, 0 quand elle est dans le plan de la figure 7 et -1 quand elle pointe vers le bas. Trois courbes, dessinant des cercles concentriques dans le cas présenté sur la figure 7, délimitent les zones respectives dans lesquelles m_{z} ∈ [-1 ; 0[ (zébrures serrées), m_{z} est égal à 0 (pas de zébrures) et m_{z} ∈ ] 0 ; 1[ (zébrures plus larges). Les variations des valeurs de m_{z} entre -1 et +1 se font de manière progressive.

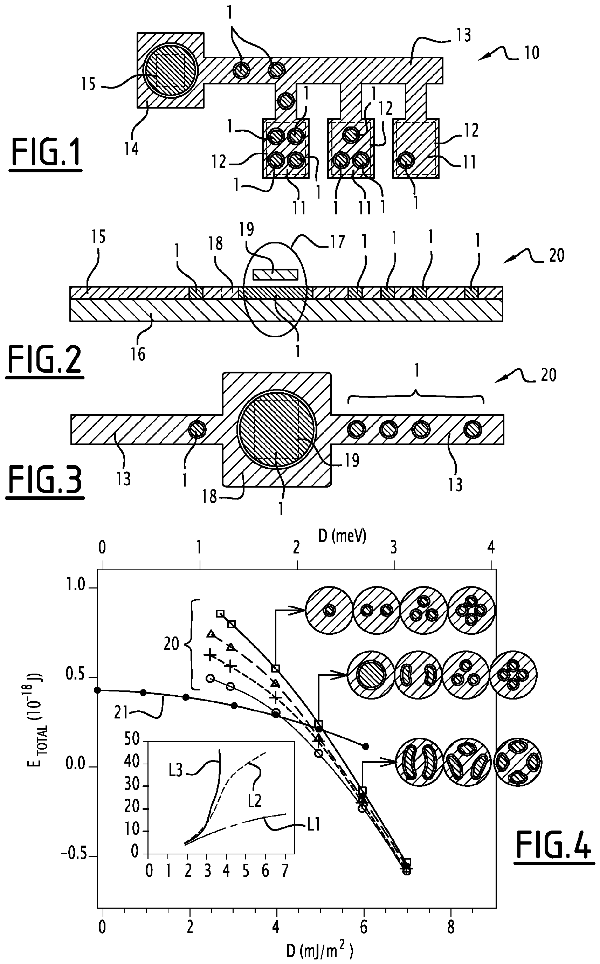

Dans un mode de réalisation de l'invention, on définit des états distincts d'un élément de mémoire à multi-états comportant une nanostructure SB et on associe chaque état défini à un nombre respectif de skyrmions. L'état de l'élément à mémoire est ainsi déterminé, lors de l'écriture et de la lecture de l'élément à mémoire, en fonction du nombre de skyrmions présentés par cet élément. Pour ce mode de réalisation, la lecture peut être faite soit en comptant le nombre de skyrmions injectés dans l'élément de mémoire en plaçant en amont un élément comme celui indiqué 13 sur la figure 3 soit en mesurant la résistance de l'élément (avec une correspondance entre résistance et nombre de skyrmions)

Par exemple, la figure 8 montre un nanoplot représentant un élément à mémoire 11, et comportant un skyrmion magnétique 1, cette valeur du nombre de skyrmions étant associée par exemple à l'état « 00 » de l'élément à mémoire. La figure 9 représente l'élément à mémoire 11 comportant deux skyrmions 1, cette valeur du nombre de skyrmions étant associée par exemple à l'état « 01 » de l'élément à mémoire. La figure 10 présente l'élément à mémoire 11 comportant trois skyrmions 1, cette valeur du nombre de skyrmions étant associée par exemple à l'état « 10 » de l'élément à mémoire. La figure 11 représente l'élément à mémoire 11 comportant quatre skyrmions 1, cette valeur du nombre de skyrmions étant associée par exemple à l'état « 11 » de l'élément à mémoire.

Il est noté qu'un état de la mémoire est associé à un nombre nul de skyrmions magnétiques dans un mode non-couvert par les revendications.

Dans un mode de réalisation de l'invention, des états distincts d'un élément de mémoire à multi-états, par exemple un nanoplot, comportant une nanostructure SB sont associés à des niveaux distincts de résistance électrique du nanoplot correspondant à une configuration magnétique chirale donnée.

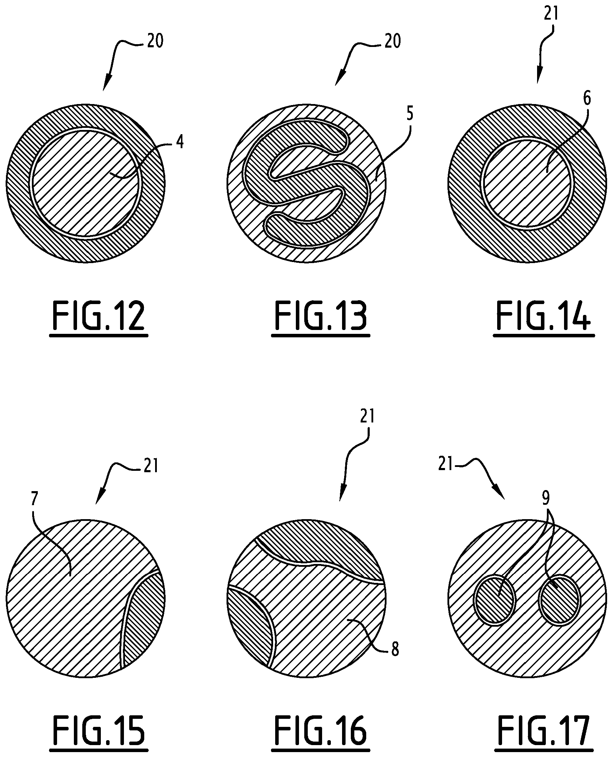

A titre d'illustration, la figure 12 montre un nanoplot représentant un élément à mémoire 20, et comportant un skyrmion magnétique 4 présentant une forme donnée, donnant lieu à une valeur Ω₁₂ de résistance électrique du nanoplot 20 comportant le skyrmion 4, cette valeur Ω₁₂ de résistance électrique étant associée par exemple à l'état « 00 » de l'élément à mémoire. La figure 13 montre le nanoplot 20, et comportant un skyrmion magnétique 5 présentant une autre forme donnée, donnant lieu à une valeur Ω₁₃ de résistance électrique du nanoplot 20 comportant le skyrmion 5, cette valeur Ω₁₃ de résistance électrique étant associée par exemple à l'état « 01 » de l'élément à mémoire.

Dans un autre mode de réalisation, à titre d'illustration, les figures respectives 14 à 17 montrent un nanoplot représentant un élément à mémoire 21 dans des états respectifs distincts « 00 », « 01 », « 10 » et « 11 » par exemple. Chacun de ces états, respectivement « 00 », « 01 », « 10 » et « 11 », correspond à une valeur distincte de résistance électrique, respectivement Ω₀₀, Ω₀₁, Ω₁₀, Ω₁₁, du nanoplot 21, qui dépend de la forme de l'ensemble de skyrmion(s) magnétique(s) figurant dans le nanoplot 21.

La configuration de l'ensemble 6 de skyrmion(s) présent dans le nanoplot 21 représenté en figure 14 nécessite l'existence d'un skyrmion. La configuration de l'ensemble 7 de skyrmion(s) présent dans le nanoplot 21 représenté en figure 15 nécessite l'existence d'un skyrmion, partiellement présent dans le nanoplot 21. La configuration de l'ensemble 8 de skyrmion(s) présent dans le nanoplot 21 représenté en figure 16 nécessite l'existence de deux skyrmions, partiellement présents dans le nanoplot 21. La configuration de l'ensemble 9 de skyrmion(s) présent dans le nanoplot 21 représenté en figure 17 nécessite l'existence de deux skyrmions présents dans le nanoplot 21.

Un dispositif à mémoire selon l'invention est adapté pour créer des skyrmions magnétiques dans un nanoplot, est adapté pour écrire un état dans un élément à mémoire de type nanoplot, et est adapté pour lire un élément à mémoire de type nanoplot et en déduire l'état.

Dans le cas considéré ici, les nanoplots ont une forme de cylindre, mais peuvent en réalité présenter une forme quelconque.

Dans un mode de réalisation d'un dispositif à mémoire selon l'invention, les moyens d'écriture du dispositif à mémoire sont adaptés pour créer de manière stabilisée un ensemble de skyrmions, en nombre défini ou présentant une résistanceélectrique définie, directement dans le nanoplot de l'élément de mémoire à écrire.

Dans un autre mode de réalisation, le ou les skyrmions sont créés de manière stabilisée dans un nanoplot distinct, par les moyens d'écriture du dispositif à mémoire dans une opération de création, par exemple dans un nanoplot servant de source de skyrmions. Puis, dans une opération d'écriture, un ou des skyrmions crées sont déplacés, par les moyens d'écriture du dispositif à mémoire, depuis ce nanoplot servant de source ou depuis un nanoplot servant de réserve entre le nanoplot source et les éléments à mémoire, vers l'élément à mémoire dont l'état est à écrire. Les déplacements de skyrmions se font par exemple dans des nanopistes réalisés en nanostructure SB reliant entre eux le nanoplot dans lequel les skyrmions ont été créés ou stockés, et le nanoplot dont l'état doit être écrit.

### Création des skyrmions et stabilisation - écriture

La figure 4 représente l'évolution de l'énergie totale E_{TOTAL} d'un nanoplot de nanstructure SB pour la phase ferromagnétique du nanoplot, et le cas échéant, pour la phase skyrmion du nanoplot, en fonction du nombre de skyrmions lorsque de tels skyrmions sont présents sur le nanoplot, et en fonction de l'amplitude du paramètre D (mJ/m²) qui reflète l'interaction magnétique appelé Dzyaloshinski-Moriya, notée DM , qui génère un ordre magnétique chiral pouvant stabiliser un skyrmion magnétique dans une nanostructure.

Chacune des courbes 20 correspond à la phase de skyrmion(s) du nanoplot, pour un nombre distinct de skyrmion(s) par élément de mémoire compris entre un et quatre. La courbe 20 comportant des ronds (o) correspond à 1 skyrmion, la courbe 20 comportant des croix (+) correspond à 2 skyrmions la courbe 20 comportant des triangles (Δ) correspond à 3 skyrmions, et la courbe 20 comportant des carrés (□) correspond à 4 skyrmions.

Une vue de dessus du nanoplot comportant le ou les skyrmions est en outre représentée pour les valeurs de D égales à 4, 5 et 7 mJ/m² à droite des courbes 20.

La courbe 21 correspond à la phase ferromagnétique du nanoplot, c'est-à-dire en l'absence de skyrmions dans l'élément mémoire.

Il apparaît clairement de ces courbes qu'au-delà d'une certaine valeur de D, la phase skyrmion (courbes 20) est métastable par rapport à la phase ferromagnétique uniforme (courbe 21), puis devient même la phase de plus basse énergie.

Selon l'invention, la création, par nucléation, et la stabilisation d'un ensemble de skyrmions magnétiques dans un nanoplot présentant un nombre souhaité de skyrmions ou encore présentant un niveau de résistance électrique souhaité sont réalisées par application locale d'un courant polarisé en spin, typiquement 10⁷ à 10⁸A/cm² en utilisant l'effet de transfert de spin, ou bien en appliquant un champ électrique local, typiquement 1 à 5 MV.cm-¹. Enfin il a été montré récemment que l'application d'un champ magnétique local, typiquement de quelques dizaines à quelques centaines de mT, pouvait permettre de stabiliser des skyrmions (Kirakosyan, A. S. & Pokrovsky, V. L. From bubble to Skyrmion: Dynamic transformation mediated by a strong magnetic tip. Journal of magnetism and magnetic materials 305, 413-422 (2006)).

En outre, dans un mode de réalisation de l'invention, pour augmenter la stabilisation du ou des skyrmions créés dans le nanoplot, une opération de modification des paramètres magnétiques (aimantation, anisotropie magnétique, interaction DM) sur les bords du nanoplot est mise en œuvre lors de la création du ou des skyrmions. Ces modifications locales pourraient être obtenues par des techniques de bombardement ionique localisé par exemple, ou bien en modifiant localement l'épaisseur du film magnétique, ou bien encore en utilisant un matériau en contact avec le film mince magnétique dans le nanoplot présentant des propriétés piezoélectriques, permettant ainsi de contrôler les paramètres structuraux et donc magnétiques du film (en effet l'interaction DM est purement interfaciale et donc est renormalisée par l'épaisseur du film magnétique, (en divisant l'épaisseur par 2, on multiple par 2 le paramètre D).

### Déplacement des skyrmions magnétiques

Comme évoqué ci-dessus, dans des modes de réalisation d'un dispositif à mémoire selon l'invention, ce dernier est adapté pour faire migrer des skyrmions depuis un nanoplot adapté pour la création des skyrmions ou pour le stockage de ces skyrmions, jusqu'à un nanoplot utilisé comme élément de mémoire adapté pour stocker un état de cet élément de mémoire, qui est selon l'invention, associé soit à un nombre non nul donné de skyrmions, soit à une niveau de résistance associé à la configuration chirale d'un ensemble de skyrmion(s) magnétique(s).

Le déplacement d'un nombre déterminé de skyrmions est opéré par effet de transfert de spin, par exemple en géométrie d'injection de courant polarisé en spin, perpendiculairement aux couches ou dans le plan de la couche à fort SOC, ou bien par application d'un champ électrique local.

Il a été récemment démontré que des réseaux de skyrmions pouvaient être déplacés par transfert de spin à des densités de courants très faibles (cf. Jonietz, F. et al. Science 330, 1648-1651 (2010)) et que des défauts avaient une faible influence sur leurs déplacements (cf .Iwasaki, J., Mochizuki, M. & Nagaosa, N. Nature Commun. 4, 1463 (2013)). Ceci permet d'obtenir un coût énergétique réduit pour le fonctionnement d'un tel dispositif à mémoire.

La polarisation en spin agissant sur le ou les skyrmions magnétiques grâce à l'effet de transfert de spin peut être obtenue par effet Hall de spin, par effet Rashba (des termes de couple de transfert sont liés directement aux effets spin orbite (SOC) dans le métal normal) ou de manière plus conventionnelle en utilisant une jonction tunnel magnétique. La particularité de ces termes de transfert de spin est qu'ils permettent d'appliquer ces couples pour faire avancer le ou les skyrmions sur l'ensemble des pistes ou éléments de la mémoire.

Dans des nanopistes de quelques dizaines de nm de largeur, des vitesses de skyrmions de quelques dizaines de m/s ont été obtenues par effet de transfert de spin, correspondant à des densités de courant de quelques MA/cm², à comparer à quelques dizaines voire quelques centaines de MA/cm² pour des mémoires magnétiques à base de parois de domaines ou de vortex.

Il est ainsi possible de déplacer des trains de skyrmions sans modifier notoirement leurs tailles, ni la distance entre deux skyrmions voisins. Cette caractéristique est utile pour l'application de l'invention aux mémoires à registre à décalage à base de skyrmions.

On notera qu'en outre, la forme des skyrmions et leur vitesse de déplacement induit par transfert de spin dans la nanopiste ne sont pas modifiées par une courbure de la nanopiste.

### Lecture

Dans un nanoplot formant un élément à mémoire d'un dispositif dont l'état, dans un mode de réalisation de l'invention, est associé à un nombre non nul respectif de skyrmions présents dans l'élément à mémoire la lecture de l'élément à mémoire comprend la détection, par le dispositif à mémoire, du nombre de skyrmions présents dans l'élément à mémoire, puis la détermination de l'état en déterminant l'état associé au nombre de skyrmions déterminé (par exemple par l'intermédiaire d'une table stockant la correspondance entre les nombres de skyrmions et les états associés).Dans un mode de réalisation, les moyens de lecture du dispositif de mémoire comprennent des moyens pour déterminer le nombre de skyrmions présents dans l'élément à mémoire, par une mesure de transport magnéto-résistif du nanoplot .

En effet, la résistance électrique ou encore la tension aux bornes du nanoplot dépendent de la présence, d'un ou plusieurs skyrmions dans le nanoplot. Un niveau de résistance ou de tension est associé à chacun des états possibles de l'élément mémoire, c'est-à-dire 1, 2 .. n skyrmions.

Dans un autre mode de réalisation selon l'invention, l'état d'un élément à mémoire d'un dispositif est associé à un niveau de résistance électrique respectif présenté par un ensemble de skyrmions présents dans l'élément à mémoire. La lecture de l'élément mémoire comprend la mesure de la résistance électrique de l'ensemble de skyrmion(s) présent dans l'élément mémoire le cas échéant, puis la détermination de l'état de l'élément mémoire en déterminant l'état associé à la résistance électrique mesurée, par exemple par l'intermédiaire d'une table associant des résistances de configurations magnétiques chirales données et les états de mémoire respectivement associés.

En effet, la résistance électrique ou encore la tension aux bornes du nanoplot dépendent de la présence ou non de skyrmion(s), ainsi que de la forme et de la taille du ou des skyrmions magnétiques présents le cas échéant.

Suivant les modes de réalisation, la mesure magnétorésistive est réalisée à l'aide d'une composante de l'effet Hall spécifiquement liée à la structure de spin des skyrmions (appelé effet Hall topologique), par contact latéral par exemple, par magnétorésistance géante notée GMR, ou encore par magnétorésistance tunnel, notée TMR en plaçant une jonction tunnel magnétique, notée MTJ, au dessus de l'élément à mémoire...).

### Taille

Comme indiqué précédemment en référence à la figure 4, une vue de dessus d'un nanoplot comportant une phase skyrmion est représentée pour les valeurs de D égales à 4, 5 et 7 à droite des courbes 20.

On déduit de ces courbes 20 que la dimension d'un skyrmion augmente avec la valeur du paramètre D. Ce résultat est l'inverse de ce qui est prédit dans les réseaux denses de skyrmions : il est possible ainsi d'obtenir les plus fortes densités de skyrmions pour les plus faibles paramètres D, i.e. pour des valeurs de couplage spin-orbite tout à fait en accord avec celle prédite dans les systèmes 2D. Comme explicité ci-après, l'invention exploite cette caractéristique pour moduler, dans un dispositif à mémoire selon l'invention, et en fonction des opérations à réaliser, la taille des skyrmions.

La taille des skyrmions individuels, i.e. en nombre fini, dans des réseaux nondenses, est ainsi déterminée par la compétition entre les différents termes d'énergies de la nanostructure (liés à l'interaction d'échange et les interactions DM) et peut atteindre des dimensions ultimes pour un objet magnétique de quelques mailles atomiques (cf. Heinze, S. et al. Nature Phys. 7, 713-718 (2011)). Cette caractéristique est exploitée selon l'invention pour limiter la taille des skyrmions magnétiques, notamment dans des nanoplots servant de source de skyrmions et des nanoplots servant de réserve ainsi que dans les nanopistes pour guider le transport des skyrmions. Cette caractéristique permet de garantir une très forte densité d'intégration des skyrmions et donc une très forte densité d'intégration de l'information à stocker.

Les courbes L1, L2 et L3 dans le cadre inséré en figure 4 représentent l'évolution du diamètre, en nm, des skyrmions en fonction de la valeur du paramètre D, dans le cas d'une nanostructure SB comportant ces skyrmions, le nanoplot présentant dans le plan de la couche ferromagnétique un diamètre de 160 nm pour la courbe L1, 80 nm pour la courbe L2 et 40 nm pour la courbe L3. Il ressort de ces courbes que les dimensions des skyrmions dépendent de la largeur du nanoplot ou de la piste contenant ces skyrmions.

Cette caractéristique est exploitée selon l'invention en créant une zone élargie de la nanostructure SB pour augmenter localement la taille du skyrmion présent dans la nanostructure, de manière à augmenter le rapport signal/bruit lors de la lecture de la zone élargie par le dispositif à mémoire, par exemple dans le cas d'une zone de comptage du nombre de skyrmions transitant un par un en un point d'une nanopiste, ou encore dans un élément à mémoire.

A titre d'illustration, une vue d'une partie d'un dispositif à mémoire 20 dans un mode de réalisation de l'invention est représentée sur la figure 2 (vue latérale) et sur la figure 3 (vue de dessus).

Ce dispositif à mémoire 20 comprend une nanostructure SB composée d'une couche supérieure ferromagnétique 15 et d'une couche inférieure à fort SOC 16 selon l'invention, comme détaillée plus haut, comportant une zone 17 comportant un nanoplot 18 et un élément de mesure 19, la nanostructure comportant en outre deux nanopistes 13 prolongeant le nanoplot de part et d'autre.

L'élément de mesure 19 est disposé au niveau du nanoplot 18 et est adapté pour déterminer la présence ou non d'un skyrmion par effet magnéto-résistif, par exemple à l'aide d'une jonction MTJ sur la zone 17, ou par contact latéral de la nanopiste par effet Hall.

Le nanoplot 18 présente une forme élargie par rapport aux nanopistes 13 (i.e. chaque dimension parmi la largeur et la longueur du nanoplot est supérieure à la dimension la plus faible de la nanopiste.

Un train de skyrmions comportant plusieurs skyrmions 1 est présent dans les nanopistes 13 et se déplace, par exemple de la droite de la figure 2 ou 3 vers la gauche, sous l'effet par exemple d'un transfert de spin mis en œuvre par le dispositif à mémoire sur ce train de skyrmions, par exemple par injection d'un courant continu dans la couche à fort SOC 16, ce qui permet de générer un courant de spin pur ayant la bonne direction de polarisation en spin pour agir sur le skyrmion ou le train de skyrmions.

Les skyrmions 1 passent ainsi l'un après l'autre dans le nanoplot 18. Comme expliqué ci-dessus, lorsqu'un skyrmion se trouve dans le nanoplot 18, sa taille s'accroît.

Lors de chaque nouveau passage de skyrmion, l'élément magnétorésistif 19 détecte ainsi la présence d'un skyrmion supplémentaire par effet magnéto-résistif, ce qui donne par exemple lieu à l'incrémentation d'un compteur de skyrmions.

Une vue partielle de dessus d'un dispositif à mémoire 10 dans un mode de réalisation de l'invention est représentée en figure 1.

Ce dispositif à mémoire met en œuvre certains des principes détaillés ci-dessus en référence aux différents aspects de l'invention.

Ce dispositif à mémoire 10 comporte une nanostructure SB selon l'invention comportant un nanoplot 14 source de skyrmions, et au moins trois nanoplots 11 correspondant chacun à un élément de mémoire, et une nanopiste reliant entre eux le nanoplot source 14 et les nanoplots éléments de mémoire 11.

La nanopiste permet le déplacement des skyrmions par transfert de spin sous forme de trains, permettant notamment une réalisation de type registre à décalage. La largeur de la nanopiste est par exemple de quelques dizaines de nm.

Des éléments magnétorésistifs 12 sont disposés au niveau de chacun des nanoplots 11. Un élément magnétorésistif 15 est en outre disposé au niveau du nanoplot de source 14.

Des moyens d'injection de courant au niveau de la nanopiste de source 14 sont adaptés pour créer lors d'une commande de création d'un skyrmion. La création de ce skyrmion est détectée par l'élément magnétorésistif 15. La détection (ou le comptage) est facilitée par la zone élargie présentée par le nanoplot de source 14, qui permet une taille accrue du skyrmion créé et donc une détection rendue plus aisée.

Chaque skyrmion une fois créé est déplacé à l'aide d'un effet de transfert de spin vers la nanopiste 13.

Suite à la réception d'une commande de lecture désignant un des nanoplots éléments de mémoire 11, le dispositif à mémoire 10 est adapté pour déterminer le nombre de skyrmions présents dans le nanoplot 11 désigné, à l'aide de l'élément magnétorésistif 12 situé au niveau du nanoplot désigné 11, et pour en déduire l'état du nanoplot désigné 11 en fonction d'une correspondance connue entre des nombre de skyrmions et des états respectifs d'éléments à mémoire.

Suite à la réception d'une commande d'écriture désignant un des nanoplots éléments de mémoire 11 et désignant en outre un état à écrire, le dispositif à mémoire 10 est adapté pour déterminer le nombre cible , non nul, de skyrmions à faire figurer dans le nanoplot 11 désigné en fonction de l'état à écrire désigné et d'une correspondance connue entre des nombre de skyrmions et des états respectifs d'éléments à mémoire.

Puis le dispositif à mémoire 10 commande la lecture du nombre de skyrmions couramment présents dans le nanoplot désigné 11, à l'aide de l'élément magnétorésistif 12 situé au niveau du nanoplot désigné 11, et en déduit le cas échéant un nombre N (N>1) de skyrmions à ajouter ou à supprimer dans le nanoplot 11 pour que le nombre résultant soit égal au nombre cible.

Dans le cas de N skyrmions à supprimer, le dispositif à mémoire 10 commande alors une extraction de N skyrmions depuis le nanoplot désigné 11, à destination de la nanopiste 13 par déplacement par effet de transfert de spin. Chaque extraction d'un skyrmion est par exemple confirmée par une opération de lecture du nanoplot 11 désigné.

Dans le cas de N skyrmions à ajouter, le dispositif à mémoire 10 commande alors une insertion de N skyrmions dans le nanoplot désigné 11, depuis la nanopiste 13 par déplacement par effet de transfert de spin. Chaque insertion d'un skyrmion est par exemple confirmée par une opération de lecture du nanoplot 11 désigné. Des commandes de création de skyrmions peuvent en outre être mises en œuvre au cas où la nanopiste ne comporterait pas suffisamment de skyrmions disponibles.

### Suppression des skyrmions

Dans un mode de réalisation, le dispositif à mémoire 10 est adapté pour supprimer un skyrmion en le déplaçant dans une région du dispositif dans laquelle les paramètres magnétiques ont été modifiés (anisotropie magnétique différente) ou bien l'épaisseur du film magnétique a été augmentée (car l'interaction DM est purement interfaciale) ou bien encore la brisure de symétrie d'inversion n'est plus présente ce qui peut être fait par la mise en place au-dessus de la couche magnétique du dispositif à mémoire, d'un film du matériau à fort SOC de même épaisseur que celui qui est en dessous.

Ainsi l'invention propose d'exploiter les propriétés intrinsèques des structures magnétiques que sont les skyrmions, comme élément de base de mémoires magnétiques non volatiles, et d'utiliser le nombre non nul de skyrmions et/ou la résistance électrique associée à la configuration chirale du ou des skyrmions, comme paramètres définissant des états d'une mémoire multi-états.

Un dispositif à mémoire selon l'invention comporte des moyens d'injecter et de stabiliser des skyrmions dans des nanostructures SB de formes variables (disques, pistes uniques, nano-circuits etc...), et dans certains modes de réalisation, des moyens de guidage des skyrmions par des modifications localisées des propriétés magnétiques des matériaux (anisotropie magnétique et/ou interaction spin-orbite).

L'utilisation des skyrmions en nombre contrôlé offre de multiples avantages :
- les dimensions des skyrmions étant définies par des compétitions entre différents termes d'énergie des systèmes considérés (et donc contrôlables), peuvent atteindre des limites ultimes de l'ordre de quelques mailles atomiques (inférieures au nanomètre), ce qui permet de répondre à la problématique d'augmentation de la densité d'information stockée ;
- la structure interne des skyrmions les rend a priori beaucoup moins sensibles aux défauts structuraux et/ou magnétiques dus par exemple à la nano fabrication, et donc facilite leur déplacement, par effet de transfert de spin, réduisant ainsi le coût énergétique du fonctionnement du dispositif à mémoire.

L'invention propose en outre des solutions pour stabiliser et injecter des skyrmions dans les éléments à mémoire du dispositif. De plus, l'invention offre une solution pour moduler fortement dans le dispositif à mémoire les dimensions des skyrmions individuels, i.e. de permettre une augmentation des dimensions des skyrmions lors de la lecture, pour en faciliter la lecture par effet magnéto-résistif, tout en permettant une réduction des dimensions des skyrmions en-dehors de ces opérations de lecture notamment, donnant lieu à une grande densité de stockage et à un fort niveau d'intégration.

L'invention peut être mise en œuvre dans des mémoires de type STT-MRAM (en anglais « Spin Transfer Torque Magnetic Random Access Memory ») par exemple, ou encore dans des mémoires de type registre à décalage, par exemple à base de bulles magnétiques et/ou de parois de domaine.

## Revendications

1. Dispositif à mémoire (10), comprenant :
- au moins un élément spintronique (11) comprenant au moins une couche ferromagnétique (15) et au moins une couche non magnétique (16) à fort couplage spin orbite interfacée avec la couche ferromagnétique (15), l'élément spintronique (11) étant adapté pour représenter un état parmi au moins n états associés à l'élément spintronique, n>1, chacun des n états étant associé à au moins une caractéristique correspondante d'un ensemble de skyrmion(s) magnétique(s) (1) dans l'élément spintronique, ledit ensemble de skyrmion(s) magnétique(s) (1) étant dans la couche ferromagnétique (15), la caractéristique associée à un état n°i étant distincte de ladite caractéristique associée à un état n°j lorsque les état n°i et j sont deux états distincts parmi les n états,
- des moyens d'écriture d'état adaptés pour recevoir un identifiant correspondant à un état parmi les au moins n états et adaptés pour modifier l'ensemble de skyrmion(s) magnétique(s) (1) dans l'élément spintronique (11) de manière à ce que la caractéristique de l'ensemble de skyrmion(s) modifié soit égale à une valeur prédéfinie associée à l'état identifié par l'identifiant correspondant reçu,
**caractérisé en ce que** :
- pour chaque état des n états, la caractéristique associée est un nombre respectif non nul de skyrmion(s) magnétique(s) (1) présent(s) dans l'élément spintronique et/ou un niveau de résistance électrique respectif de l'ensemble de skyrmion(s) magnétique(s) associé à la configuration chirale de chaque skyrmion magnétique (1) dudit ensemble de skyrmion(s) magnétique(s).

2. Dispositif à mémoire (10) selon la revendication 1, dans lequel les moyens d'écriture d'état comprennent des moyens de création de skyrmion(s) adaptés pour appliquer localement à l'élément spintronique (11), ou à un autre élément spintronique dans le dispositif à mémoire et relié à l'élément spintronique par une piste (13) de déplacement des skyrmions, un courant polarisé en spin ou un champ électrique local ou un champ magnétique local pour créer un nombre déterminé de skyrmion(s).

3. Dispositif à mémoire (10) selon la revendication 2, dans lesquels les moyens de création de skyrmion(s) sont adaptés pour stabiliser énergétiquement l'état dudit élément (11) ou autre élément spintronique en fonction dudit nombre de skyrmions à créer et de la relation entre l'énergie magnétique et l'interaction magnétique chirale de l'élément spintronique.

4. Dispositif à mémoire (10) selon la revendication 3, dans lequel les moyens d'écriture d'état comprennent des moyens de stabilisation dudit ou desdits skyrmion(s) créé(s) sur ledit élément (11), ou autre élément, spintronique, par modification d'au moins un paramètre magnétique sur les bords dudit élément, ou autre élément, spintronique.

5. Dispositif à mémoire (10) selon l'une quelconque des revendications précédentes, comprenant des moyens de lecture d'état adaptés pour mesurer la magnétorésistance dudit élément spintronique (11) ou d'un autre élément spintronique du dispositif à mémoire et pour déterminer, en fonction d'au moins ladite magnétorésistance mesurée, l'état associé à l'élément spintronique parmi les n états.

6. Dispositif à mémoire (10) selon la revendication 5, dans lequel lesdits moyens de lecture d'état sont adaptés pour déterminer, en fonction d'au moins ladite magnétorésistance mesurée, un nombre de skyrmions présents dans ledit élément spintronique (11) et pour en déduire l'état de l'élément spintronique comme égal à l'état associé audit nombre de skyrmions déterminé.

7. Dispositif à mémoire (10) selon l'une quelconque des revendications précédentes, comprenant une piste (13) permettant le déplacement de skyrmions, l'un après l'autre, par effet de transfert de spin, comprenant, en un point le long de la piste, une zone élargie et des moyens de lecture adaptés pour mesurer la résistance électrique d'un l'élément spintronique dans la zone élargie.

8. Dispositif à mémoire (10) selon l'une quelconque des revendications précédentes, dans lequel la couche ferromagnétique comprend au moins un matériau parmi Fe, Co ou Ni, un péreovskite férromagnétique simple ou double à base de Ti, Cr, Mn, Fe Co Mo ou Ru, un alliage Heusler à base de Fe, Co ou Ni ou un semi-conducteur magnétique.

9. Dispositif à mémoire (10) selon l'une quelconque des revendications précédentes, dans lequel la couche non magnétique comprend au moins un matériau parmi les éléments Pt, W, Ir, Re, Ta, Pb, Bi Rh, Pd, Mo, Cu ou encore Sm, Gd, Tb ou Er..

10. Procédé de traitement dans un dispositif à mémoire (10) selon l'une quelconque des revendications précédentes, ledit procédé comportant une étape d'association de chacun des n états à ladite au moins une caractéristique correspondante dudit ensemble de skyrmion(s) magnétique(s) (1) dans l'élément spintronique.

## Patentansprüche

1. Speichervorrichtung (10), umfassend:
- mindestens ein spintronisches Element (11), umfassend mindestens eine ferromagnetische Schicht (15) und mindestens eine nicht-magnetische Schicht (16) mit starker Spin-Bahn-Kopplung, die mit der ferromagnetischen Schicht (15) interferiert,
wobei das spintronische Element (11) angepasst ist, um einen von mindestens n Zuständen darzustellen, die mit dem spintronischen Element assoziiert sind, n>1, wobei jeder der n Zustände mit mindestens einer entsprechenden Charakteristik einer Gruppe von magnetischen Skyrmion(en) (1) in dem spintronischen Element assoziiert ist, wobei der Satz magnetischer Skyrmionen (1) in der ferromagnetischen Schicht (15) ist, wobei sich die Charakteristik, die mit einem Zustand Nr. i assoziiert Merkmal von dem einem Zustand Nr. j unterscheidet, wenn die Zustände Nr. i und j zwei verschiedene der n Zustände sind,
- Zustandsschreibeinrichtungen, die angepasst sind, um eine Kennung zu empfangen, die einem Zustand unter den mindestens n Zustände entspricht, und angepasst sind, um den Satz magnetischer Skyrmionen (1) in dem Spintronikelement (11) zu modifizieren, sodass die Charakteristik des modifizierten Satzes von Skyrmionen gleich einem vordefinierten Wert ist, der mit dem Zustand assoziiert ist, der durch die empfangene entsprechende Kennung identifiziert ist, **dadurch gekennzeichnet, dass**:
- für jeden Zustand der n Zustände die assoziierte Charakteristik eine jeweilige von null verschiedene Anzahl von magnetischen Skyrmionen (1) ist, die in dem spintronischen Element vorhanden sind, und/oder ein jeweiliges elektrisches Widerstandsniveau des Satzes von magnetischen Skyrmionen, das mit der chiralen Konfiguration jedes magnetischen Skyrmions (1) des Satzes von magnetischen Skyrmionen assoziiert ist.

2. Speichervorrichtung (10) nach Anspruch 1, wobei die Zustandsschreibeinrichtungen Einrichtungen zum Erzeugen von Skyrmion(en) umfassen, die angepasst sind, um lokal auf das spintronische Element (11) oder an ein anderes spintronisches Element in der Speichervorrichtung, das über eine Skyrmion-Bewegungsspur (13) mit dem spintronischen Element assoziiert ist, einen spinpolarisierten Strom oder ein lokales elektrisches Feld oder ein lokales Magnetfeld anzuwenden, um eine bestimmte Anzahl von Skyrmion(en) zu erzeugen.

3. Speichervorrichtung (10) nach Anspruch 2, wobei die Mittel zum Erzeugen von Skyrmion(en) angepasst sind, um den Zustand des Elements (11) oder eines anderen spintronischen Elements abhängig von der Anzahl der zu erzeugenden Skyrmionen und dem Verhältnis zwischen der magnetischen Energie und der chiralen magnetischen Wechselwirkung des spintronischen Elements energetisch zu stabilisieren.

4. Speichervorrichtung (10) nach Anspruch 3, wobei die Zustandsschreibeinrichtungen Einrichtungen zum Stabilisieren des oder der Skyrmion(en) umfassen, die auf dem Element (11) oder einem anderen Element, der Spintronik, durch Änderung mindestens eines magnetischen Parameters an den Rändern des spintronischen Elements oder anderen spintronischen Elements erzeugt werden.

5. Speichervorrichtung (10) nach einem der vorherigen Ansprüche, umfassend Zustandsleseeinrichtungen, die angepasst sind, um den Magnetowiderstand des spintronischen Elements (11) oder eines anderen spintronischen Elements der Speichervorrichtung zu messen und abhängig von mindestens dem gemessenen Magnetowiderstand den dem spintronischen Element assoziierten Zustand unter n Zuständen zu bestimmen.

6. Speichervorrichtung (10) nach Anspruch 5, wobei die Zustandsleseeinrichtungen geeignet sind, abhängig von mindestens dem gemessenen Magnetowiderstand eine Anzahl von Skyrmionen zu bestimmen, die in dem spintronischen Element (11) vorhanden sind, und daraus den Zustand des spintronischen Elements als gleich dem Zustand abzuleiten, der mit der bestimmten Anzahl von Skyrmionen assoziiert ist.

7. Speichervorrichtung (10) nach einem der vorherigen Ansprüche, umfassend eine Spur (13), die die Bewegung von Skyrmionen, eines nach dem anderen, durch den Spin-Transfer-Effekt ermöglicht, umfassend an einem Punkt entlang der Spur einen erweiterten Bereich und Leseeinrichtungen, die angepasst sind, den elektrischen Widerstand eines spintronischen Elements in dem erweiterten Bereich zu messen.

8. Speichervorrichtung (10) nach einem der vorherigen Ansprüche, wobei die ferromagnetische Schicht mindestens ein Material von Fe, Co oder Ni, einen einfachen oder doppelten ferromagnetischen Perowskit auf der Basis von Ti, Cr, Mn, Fe Co Mo oder Ru, eine Heusler-Legierung auf der Basis von Fe, Co oder Ni oder einen magnetischen Halbleiter umfasst.

9. Speichervorrichtung (10) nach einem der vorherigen Ansprüche, wobei die nicht-magnetische Schicht mindestens ein Material von den Elementen Pt, W, Ir, Re, Ta, Pb, Bi Rh, Pd, Mo, Cu oder auch Sm, Gd, Tb oder Er umfasst.

10. Verarbeitungsverfahren in einer Speichervorrichtung (10) nach einem der vorherigen Ansprüche, wobei das Verfahren einen Schritt eines Assoziierens von jedem der n Zustände mit der mindestens einen entsprechenden Charakteristik des Satzes von magnetischen Skyrmionen (1) in dem spintronischen Element umfasst.

## Claims

1. A memory device (10), comprising:
- at least one spintronic element (11) comprising at least one ferromagnetic layer (15) and at least one non-magnetic layer (16) with strong spin-orbit interfaced with the ferromagnetic layer (15),
the spintronic element being adapted for representing a state from among at least n states associated with the spintronic element, n > 1, each of the n states being associated with at least one corresponding characteristic of a set of magnetic skyrmions (1) in the spintronic element, said set of magnetic skyrmions being in the ferromagnetic layer (15), the characteristic associated with a state n°i being distinct from said characteristic associated with a state n°j when the states n°i and j are two distinct states from among the n states,
- state writing means adapted for receiving a identifier corresponding to a state from among said at least n states and adapted for modifying the set of the magnetic skyrmions (1) in the spintronic element (11) so that the characteristic of the modified set of skyrmions is equal to a predefined value associated with the state identified by the corresponding received identifier,
**characterized in that**
- for each state of the n states, the associated characteristic is a non-zero respective number of magnetic skyrmion(s) (1) present in the spintronic element and/or a respective electric resistance level of the set of the magnetic skyrmion(s) associated to the chiral configuration of each magnetic skyrmion of said set of magnetic skyrmions

2. The memory device (10) according to claim 1, wherein the state writing means comprise means for generating skyrmion(s) adapted for locally applying to the spintronic element (11), or to another spintronic element in the memory device and connected to the spintronic element by a track (13) for displacement of the skyrmions, a spin-polarized current or a local electric field or a local magnetic field for generating a determined number of skyrmion(s).

3. The memory device (10) according to claim 2, wherein the means for generating skyrmion(s) are adapted for energetically stabilizing the state of said element (11) or other spintronic element depending on the number of skyrmions to be generated and on the relationship between the magnetic energy and chiral magnetic interaction of the spintronic element.

4. The memory device (10) according to claim 3, wherein the state writing means comprise means for stabilizing said skyrmion(s) generated on said element (11), or other spintronic element, by modifying at least one magnetic parameter on the edges of said element or other spintronic element.

5. The memory device (10) according to any one of the preceding claims, comprising state reading means adapted for measuring the magneto-resistance of said spintronic element (11) or of another spintronic element of the memory device and for determining, according to at least said measured magneto-resistance, the state associated with the spintronic element from among the n states.

6. The memory device (10) according to claim 5, wherein said state reading means are adapted for determining, according to at least said measured magneto-resistance, a number of skyrmions present in said spintronic element (11) and for inferring therefrom the state of the spintronic element as equal to the state associated with said determined number of skyrmions.

7. The memory device (10) according to any one of the preceding claims, comprising a track (13) allowing displacement of skyrmions, one after the other, by a spin transfer effect, comprising, in a point along the track, a widened area and adapted reading means for measuring the electric resistance of a spintronic element in the widened area.

8. The memory device (10) according to any one of the preceding claims, wherein the ferromagnetic layer comprises at least one material from among Fe, Co or Ni, a simple or double ferromagnetic perovskite based on Ti, Cr, Mn, Fe, Co, Mo or Ru, a Heusler alloy based on Fe, Co or Ni or a magnetic semi-conductor.

9. The memory device (10) according to any one of the preceding claims, wherein the non-magnetic layer comprises at least one material from among the elements Pt, W, Ir, Re, Ta, Pb, Bi, Rh, Pd, Mo, Cu or further Sm, Gd, Tb or Er.

10. A processing method in a memory device (10) according to any one of the preceding claims, said method comprising a step of association of each of the n states to said at least one corresponding characteristic of said set of magnetic skyrmions (1) in the spintronic element.
